Europäisches Patentamt

European Patent Office

Office européen des brevets

(11) Numéro de publication: **0 316 222 B1**

# (12) FASCICULE DE BREVET EUROPEEN

(45) Date de publication de fascicule du brevet: **30.12.92**  (51) Int. Cl.⁵: **H01L 31/02**, G01T 1/00

(21) Numéro de dépôt: **88402781.4**

(22) Date de dépôt: **04.11.88**

(54) **Dispositif de prise d'image radiologique.**

(30) Priorité: **10.11.87 FR 8715534**

(43) Date de publication de la demande:
**17.05.89 Bulletin  89/20**

(45) Mention de la délivrance du brevet:
**30.12.92 Bulletin  92/53**

(84) Etats contractants désignés:
**DE GB NL**

(56) Documents cités:
**EP-A- 0 125 691**
**US-A- 4 288 264**

**PATENT ABSTRACTS OF JAPAN, vol. 2, no.
129 (E-78), 27 octobre 1978, page 7849 E 78 &
JP-A-53 96 787 (TOKYO SHIBAURA DENKI
K.K.) 24-08-1978**

**PATENT ABSTRACTS OF JAPAN, vol. 2, no.
129 (E-78), 27 octobre 1978, page 7849 E 78 &
JP-A-53 96 785 (TOKYO SHIBAURA DENKI
K.K.) 24-08-1987**

**PATENT ABSTRACTS OF JAPAN, vol. 7, no.
253 (P-235)[1398], 10 novembre 1983, page
134 P 235 & JP-A-58 137 782 (FUJI XEROX
K.K.) 16-08-1983**

**PATENT ABSTRACTS OF JAPAN, vol. 2, no.
129 (E-78), 27 octobre 1978, page 7851 E 78 &
JP-A-53 96 791 (TOKYO SHIBAURA DENKI
K.K.) 24-08-1978**

**PATENT ABSTRACTS OF JAPAN, vol. 9, no.
68 (P-344)[1791], 28 mars 1985, page 1 P 344
& JP-A-59 200 983 (TOSHIBA K.K.) 14-11-1984**

(73) Titulaire: **THOMSON-CSF
51, Esplanade du Général de Gaulle
F-92800 Puteaux(FR)**

(72) Inventeur: **Henry, Yves**
**THOMSON-CSF SCPI 19, avenue de Messine
F-75008 Paris(FR)**
Inventeur: **Arques Marc**
**THOMSON-CSF SCPI 19, avenue de Messine
F-75008 Paris(FR)**

(74) Mandataire: **Guérin, Michel et al**
**THOMSON-CSF SCPI B.P. 329
F-92402 COURBEVOIE CEDEX(FR)**

# Description

L'invention concerne l'élaboration d'images radiologiques par l'intermédiaire d'éléments photosensibles associés à un scintillateur.

Le scintillateur est une substance qui a la propriété d'être excitée par des rayons X et d'émettre, en réponse à cette excitation, un rayonnement de longueur d'onde visible ou proche du visible. Les éléments photosensibles fournissent un signal électrique lorsqu'ils reçoivent ce rayonnement visible, alors qu'ils ne pourraient pas fournir directement un signal électrique en réponse à une illumination par les rayons X. Ainsi, on peut transformer une image radiologique en un ensemble de signaux électriques représentant cette image.

On ne décrira l'invention que pour ce type de scintillateur effectuant une conversion d'une gamme de longueurs d'onde très courte (rayons X) en une gamme de longueurs d'onde plus grande (lumière visible ou proche du visible), mais on comprendra à la lecture de la description qui suit que l'invention serait applicable dans des cas de conversion de gammes de longueurs d'onde différentes du cas particulier ci-dessus (pourvu qu'on dispose d'une substance scintillatrice effectuant la conversion de longueur d'ondes désirée).

Les dispositifs de reproduction électrique d'images radiologiques décrits jusqu'à maintenant comportent soit un élément de détection photosensible ponctuel, soit une barrette linéaire d'éléments photosensibles, soit encore une matrice rectangulaire d'éléments. Le ou les éléments sont en général des photodiodes ou phototransistors formés sur un substrat isolant et ils sont recouverts d'une feuille de matériau scintillateur qui est soit collée sur la surface supérieure des éléments photosensibles (du côté d'arrivée du rayonnement X) soit simplement appliquée par pression sur cette surface supérieure.

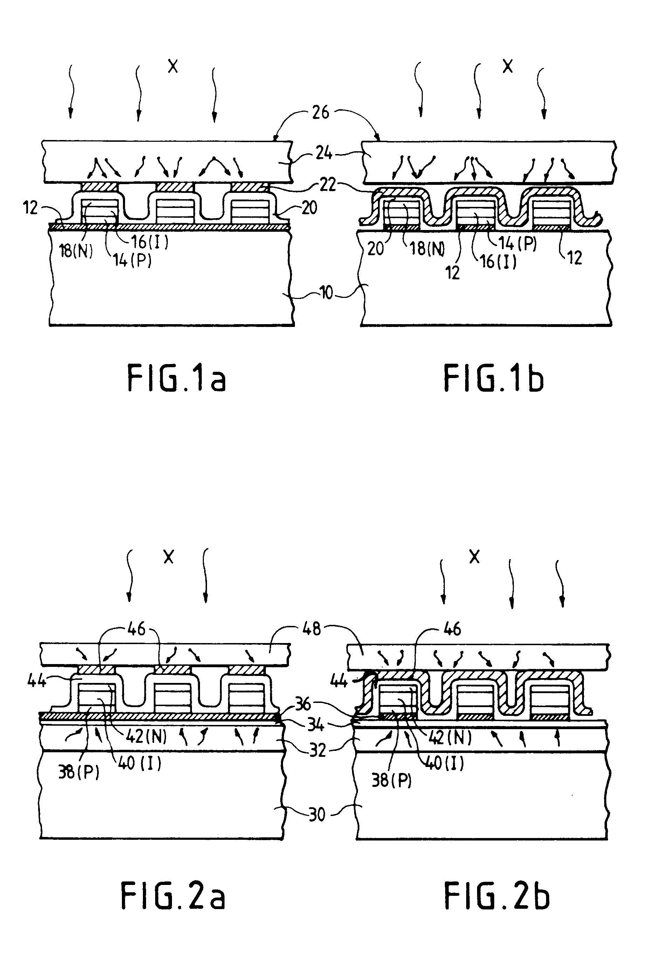

Les figures 1a et 1b représentent deux coupes latérales, orthogonales l'une à l'autre, d une matrice d'éléments photosensibles associée classiquement à une feuille scintillatrice.

Chaque élément photosensible est constitué par exemple par une diode PIN (jonction PN avec une partie centrale intrinsèque), et le réseau matriciel comporte des conducteurs de colonne et des conducteurs de ligne avec à chaque croisement de ligne et de colonne une diode PIN en série avec une capacité (ou condensateur) de stockage de charges. Les conducteurs de colonne 12 sont constitués par un métal déposé et photogravé sur un substrat isolant 10, de préférence en verre; la diode PIN est formée par dépôt sur les conducteurs de colonne, puis gravure, de trois couches de silicium amorphe respectivement dopées de type P (couche 14), de type intrinsèque (couche 16), et de type N (couche 18); une couche isolante 20 est déposée sur l'ensemble des diodes PIN, cette couche constituant le diéléctrique de la capacité; un conducteur, de préférence treansparent, est déposé sur la couche isolante 20 et gravé pour former les conducteurs de ligne 22 de la matrice. Enfin, une feuille scintillatrice 24 est collée ou appliquée par pression sur la surface supérieure de la structure.

Le rayonnement à convertir, c'est-à-dire le rayonnement X dans le cas de l'imagerie radiologique, arrive par le haut et frappe la surface supérieure 26 du scintillateur. S'il arrivait par le bas, il aurait à traverser le substrat de verre, les conducteurs de ligne et de colonne et les diodes photosensibles; il en résulterait, principalement à cause du verre, des pertes qu'on souhaite éviter pour ne pas perdre une partie des informations, surtout les informations à bas niveau.

Plus le scintillateur est épais, plus les photons émis sous l'action du rayonnement X sont nombreux; à la limite, pour une épaisseur infinie, tout le rayonnement X est absorbé et est converti en photons lumineux. Mais inversement, si le scintillateur est trop épais, les photons émis du côté opposé au détecteur photosensible seront absorbés au cours de leur trajet à travers le scintillateur (qui n'est pas complètement transparent) et ne parviendront pas au détecteur photosensible; ces photons seront perdus sans profit. Un compromis d'épaisseur doit en général être trouvé. Un ordre de grandeur est par exemple de 200 micromètres.

D'autre part, pour les scintillateurs réalisés sous forme d'une feuille de poudre compactée, la résolution est d'autant plus faible que l'épaisseur de la feuille est plus grande; en effet, les photons sont émis dans toutes les directions, et en pratique les photons émis à une distance d de l'élément photosensible produisent une tache lumineuse dont la densité est répartie selon une loi gaussienne, le diamètre utile approximatif de cette tache étant sensiblement égal à la distance d. Là encore, une épaisseur trop grande doit être évitée et un compromis doit être trouvé pour le couple résolution/sensibilité.

Des matrices de détection radiologique sont connues par exemple par le document EP A 0125691.

L'invention résulte de la remarque que dans la structure des figures 1a et 1b, le côté du scintillateur qui est frappé en premier par les rayons X est le côté 26 et non le côté en contact avec les diodes photosensibles. Il en résulte que les photons lumineux les plus nombreux sont émis du côté qui est frappé en premier.

Or justement ce sont les photons émis du côté éloigné de la surface du détecteur photosensible qui tendent à limiter à la fois la sensibilité (parce que ces photons n'arrivent pas tous à traverser la feuille) et la résolution (parce qu'ils sont émis loin de la surface photosensible). Une amélioration de la sensibilité d'un détecteur individuel a été obtenue en plaçant le scintillateur derrière le détecteur par rapport au côté d'arrivée des rayons X ; voir JP A 59 200983.

Un but de l'invention est d'améliorer aussi bien la résolution que la sensibilité du dispositif, et ceci sans qu'il devienne nécessaire d'utiliser des scintillateurs à structure cristalline très particulière, déposés sous forme d'aiguilles verticales (scintillateurs à iodure de césium) permettant une haute résolution.

Un autre but de l'invention est de faciliter la fabrication du dispositif en évitant des accidents dus à la fragilité de la feuille scintillatrice qui est une feuille très mince (200 microns environ).

Selon l'invention, on propose de constituer un dispositif de conversion d'image en signaux électriques comprenant d'une part une barrette ou matrice d'éléments photosensibles en couches minces déposées et photogravées sur un substrat isolant et d'autre part une substance scintillatrice, caractérisé en ce que la substance scintillatrice est déposée sur le substrat et intercalée entre le subtrat et les éléments photosensibles. La substance scintillatrice est une feuille collée contenant une poudre scintillatrice, ou une pâte déposée par étalement ou sédimentation et recuite. Le détecteur est une barrette d'éléments photosensibles ou une matrice d'éléments. Ces éléments sont formés par dépôt de couches actives successives sur le substrat recouvert préalablement d'une couche de substance scintillatrice. De préférence une couche isolante de planarisation est déposée au dessus de la couche scintillatrice avant dépôt des éléments photosensibles, afin de compenser les petites inégalités d'épaisseur de la couche scintillatrice et d'empêcher la diffusion d'atomes dopants dans les couches semiconductrices constituant les éléments photosensibles.

Dans une variante de réalsation, et dans le but d'augmenter la sensibilité du dispositif, on prévoit aussi une feuille scintillatrice auxiliaire, appliquée contre la surface supérieure du détecteur photosensible, de sorte que le rayonnement à convertir frappe d'abord cette feuille scintillatrice qui émet un rayonnement vers le détecteur par le haut, et que le rayonnement résiduel à convertir (celui qui n'a pas été absorbé par la feuille) frappe la substance scintillatrice déposée sur le substrat, cette dernière émettant un rayonnement vers le détecteur par le bas de celui-ci. On peut d'ailleurs prévoir que les scintillateurs ont des spectres d'absorption différents pour couvrir une plus large gamme de longueurs d'onde de rayonnement reçu.

Par ailleurs on peut prévoir d'intercaler un miroir réfléchissant (pour la longueur d'onde émise par le scintillateur), intercalé entre le substrat isolant et la substance scintillatrice déposée. Ce miroir renvoie vers le détecteur photosensible les photons qui pourraient être émis par le scintillateur dans la direction opposée au détecteur.

D'autres caractéristiques et avantages de l'invention apparaîtront à la lecture de la description détaillée qui suit et qui est faite en référence aux dessins annexés dans lesquels:

- les figures 1a et 1b déjà décrites représentent en coupe latérale selon deux directions orthogonales un dispositif de prise d'image radiologique de la technique antérieure;
- les figures 2a et 2b sont des coupes latérales selon deux directions orthogonales d'un dispositif matriciel de prise d'image selon l'invention.

Le dispositif selon l'invention va être décrit en faisant référence à son procédé de fabrication.

On part d'un substrat isolant 30 qui est de préférence en une substance transparente aux longueurs d'onde émises par le scintillateur dans l'application considérée. Cette transparence n'est pas absolument nécessaire mais elle petit avoir un intérêt dans les applications où le détecteur photosensible doit être périodiquement déchargé par un flash lumineux. Pour les applications radiologiques avec détecteur photosensible en silicium amorphe on prendra de préférence un substrat de verre.

Pour des dispositifs de grande dimension, par exemple de plusieurs dizaines de centimètres de coté, le verre doit être assez épais pour être rigide : plusieurs millimètres d'épaisseur peuvent être nécessaires et on comprendra par conséquent qu'il soit préférable d'illuminer le dispositif par la surface supérieure plutôt qu'à travers le verre qui absorberait une fraction du rayonnement.

Sur le substrat isolant 30, on dépose une substance scintillatrice 32 apte à convertir un rayonnement dans une première gamme de longueurs d'onde en un rayonnement dans une deuxième gamme de longueurs d'onde; la première gamme est celle de la source d'illumination par l'intermédiaire de laquelle est produite une image que l'on désire convertir en signaux électriques. La deuxième gamme doit correspondre à la gamme de sensibilité du détecteur photosensible.

Par example l'oxysulfure de gadolinium est apte à convertir des rayons X en rayonnement lumineux vert (550 nanomètres environ). Les détecteurs photosensibies en silicium amorphe sont sensibles à ce rayonnement vert.

La substance photosensible peut être déposée sur le substrat de plusieurs manières possibles.

Une méthode consiste simplement à prendre une feuille scintillatrice classique et à la coller sur le substrat avec une colle compatible avec les températures de traitement qui seront utilisées dans les phases suivantes. La feuille est par exemple constituée par une résine thermodurcissable dans laquelle on a noyé une poudre scintillatrice telle que de l'oxysulfure de gadolinium. La feuille peut aussi être réalisée en une résine époxy si les températures de traitement ultérieures sont suffisamment basses.

Une autre méthode consisterait à étaler une pâte visqueuse (par prédépôt et centrifugation par exemple) sur le substrat, cette pâte étant constituée par un liant mélangé à une poudre scintillatrice, et à cuire la pâte pour en éliminer les solvants volatils. Le liant peut être une résine époxy si l'on n'a pas besoin de tenue en température pour les phases ultérieures; ce peut être aussi un polyimide, auquel cas on mélange le liant et la poudre, on dépose le mélange, et on effectue une polymérisation (imidisation) ensuite. Enfin, le liant peut être un liant inorganique (minéral): par exemple on utilise un mélange de poudre scintillatrice et de billes de verre en suspension dans un solvant volatil, et on effectue un traitement à haute température (environ 500°C) dans lequel les billes de verre se fusionnent les unes aux autres et se fusionnent au substrat. Ce dernier procédé est particulièrement utile si les traitements ultérieurs se font à des températures dépassant 200°C.

La couche scintillatrice 32 a une épaisseur qui est choisie pour optimiser l'efficacité de production de photons sans trop perdre sur la résolution. Cette épaisseur petit aller de quelques dizaines à quelques centaines de micromètres pour les applications d'imagerie radiologique avec de l'oxysulfure de gadolinium.

Après dépôt et traitement de la couche scintillatrice 32, on dépose une couche isolante intermédiaire 34 qui a pour fonction notamment de planariser la surface supérieure de la couche 32 avant dépôt des éléments photosensibles, et de faire une barrière à la diffusion d'impuretés entre la couche scintillatrice et les éléments photosensibles.

La couche isolante intermédiaire peut être en polyimide, par exemple vendu sous la référence P12555 par la société DUPONT DE NEMOURS; elle est déposée par centrifugation, après quoi elle est complètement polymérisée après un recuit à 150°C durant une heure. Son épaisseur est d'environ 2 à 10 micromètres.

On dépose alors une mince couche 36 (100 nanomètres environ) d'un matériau conducteur transparent à la longueur d'onde émise par le scintillateur; ce conducteur peut être de l'oxyde d'indium-étain; il est gravé selon un motif de colonnes parallèles.

L'adhérence du matériau conducteur petit être améliorée par un dépôt préalable d'une mince couche intermédiaire non représentée; dans le cas de l'oxyde d'indium-étain, l'adhérence peut être améliorée par une couche de 20 nanomètres environ de cuivre ou de chrome.

Sur la structure ainsi recouverte de colonnes conductrices, on dépose une couche 38 de silicium amorphe hydrogéné, par décomposition chimique en phase gazeuse (CVD), éventuellement assistée par une excitation lumineuse dans l'ultraviolet (photoCVD) de manière à fonctionner à plus basse température (inférieure à 150°C).

La couche de silicium 38 est dopée avec une impureté de type P, de préférence du bore, ainsi qu'avec du carbone qui a l'avantage de la rendre plus transparente aux photons émis par le scintillateur.

De la même manière on dépose ensuite une couche de silicium amorphe hydrogéné intrinsèque 40.

Puis on dépose une couche de silicium amorphe hydrogéné 42 dopée avec une impureté de type N, de préférence du phosphore.

On a ainsi constitué, au dessus des conducteurs de colonne une succession de trois couches respectivement de type P, de type I (intrinsèque), et de type N. On pourra constituer des diodes PIN verticales à l'aide de ces trois couches, diodes qui constituent les éléments photosensibles proprement dits générant des charges électriques en présence d'un rayonnement de longueur d'onde visible.

L'étape suivante du procédé de fabrication consiste en une gravure des trois couches superposées 38, 40, 42 selon un motif d'îlots placés à chacun des points de croisement des lignes et colonnes d'une matrice rectangulaire; les colonnes de cette matrice ont déjà été définies et sont les conducteurs de la couche 36.

On recouvre alors l'ensemble de la structure d'une couche isolante 44, en oxyde ou nitrure de silicium par example, puis d'une couche conductrice supérieure 46 que l'on grave pour définir les conducteurs de ligne de la matrice.

Si le dispositif ne comporte qu'un seul scintillateur, c'est à dire la couche 32, la couche conductrice 46 peut être transparente ou non; il peut même être avantageux qu'elle soit réfléchissante (mais transparente aux rayons X) pour ramener vers la diode PIN les photons lumineux qui auraient pu la traverser sans être absorbée. Si au contraire le dispositif comporte un scintillateur inférieur (couche 32) et un scintillateur supérieur 48 analogue à celui des figures 1a et 1b, il est nécessaire que la couche conductrice supérieure 46 soit transparente et elle est alors réalisée comme la couche 36, par exemple en oxyde d'indium-étain.

Dans le type de matrice de photodétecteurs décrite ici à titre d'exemple, chaque photodiode est réalisée par empilement de couches verticales et est associée à une capacité de stockage de charges également empilée au dessus de la photodiode; cette structure minimise l'encombrement latéral de chaque point. Ici, la capacité est constituée par la couche isolante 44 entre une deux régions conductrices qui sont respectivement la région N 42 de la photodiode et le conducteur de ligne 46. Cependant l'invention serait applicable à d'autres types de matrices de photodétecteurs, par exemple des photodiodes associées chacune à un transistor d'accès de type TFT (de l'anglais Thin Film Transistor ou transistor en couche mince).

Dans une variante de réalisation, une couche réfléchissante, non représentée sur les figures, est intercalée entre la couche scintillatrice 32 et le substrat; la couche est apte à réfléchir les longueurs d'onde émises par le scintillateur 32, de sorte que les photons émis par la couche scintillatrice vers l'arrière (vers le substrat 30) sont renvoyés vers les photodiodes PIN. On gagne ainsi sur le rendement global de la structure puisqu'on convertit en charges électriques un certain nombre de photons qui seraient perdus autrement. La couche réfléchissante peut être une couche d'aluminium déposée sur le substrat de verre avant dépôt de la couche scintillatrice 32.

Dans le cas où la structure comprend aussi un scintillateur 48 collé ou pressé sur la surface supérieure des éléments photosensibles, on peut aussi prévoir que ce scintillateur 48 soit recouvert d'une couche réfléchissante non représentée, collée ou déposée sur la surface supérieure du scintillateur 48. Cette couche doit réfléchir les photons émis vers le haut par le scintillateur 48, photons qui autrement ne participeraient pas à l'élaboration d'un signal électrique dans les photodiodes; mais cette couche doit nécessairement être très transparente vis-à-vis des rayons X incidents. Ce peut être de l'aluminium.

Dans des applications particulières, on pourra envisager que les scintillateurs inférieur (32) et supérieur (48) sont de nature différente et scintillent en réponse à des longueurs d'onde incidentes différentes. On couvre ainsi un spectre de rayons incidents plus large.

On peut aussi envisager que ces scintillateurs sensibles à des longueurs d'onde différentes émettent à des longueurs d'onde également différentes, par exemple en lumière visible rouge et en lumière visible verte; on peut alors prévoir qu'un élément photodétecteur sur deux (ou une ligne sur deux, ou une colonne sur deux) est affecté à l'une des deux longueurs d'onde; cet élément est masqué par une couche opaque à l'autre longueur d'onde mais transparente aux rayons X; réciproquement les autres éléments sont masqués par une couche opaque à la première longueur d'onde et transparente aux rayons X. On prévoit donc un masque en damier de zones opaques et transparentes à l'une des longueurs d'onde; ce masque est constitué dans une couche intercalée entre la couche 34 (polyimide de planarisation) et les photodiodes; et on prévoit un autre masque en damier de zones opaques et transparentes à l'autre longueur d'onde; ce masque est constitué par une couche intercalée entre la surface supérieure des éléments photosensibles et le scintillateur supérieur 48. Cette structure permet de recueillir, en vue d'un traitement d'images, plus d'information que si on utilise une seule substance scintillatrice pour les couches 32 et 48. En particulier, dans la radiologie médicale, on peut se servir de cette structure pour traiter les images du corps humain afin d'éliminer le squelette.

## Revendications

1. Dispositif de conversion d'image en signaux électriques, comprenant d'une part une barrette ou matrice d'éléments photosensibles en couches minces déposées et photogravées (38, 40, 42) sur un substrat isolant (30) et d'autre part une substance scintillatrice (32), caractérisé en ce que la substance scintillatrice est déposée sur le substrat et intercalée entre le substrat et les éléments photosensibles.

2. Dispositif selon la revendication 1 caractérisé en ce qu'une couche isolante de planarisation (34) est intercalée entre la substance scintillatrice (32) et les éléments photosensibles.

3. Dispositif selon la revendication 2, caractérisé en ce que la couche isolante de planarisation (34) est en polyimide.

4. Dispositif selon l'une des revendications 1 à 3, caractérisé en ce que la couche scintillatrice (32) est une feuille de résine chargée d'une poudre scintillatrice, cette feuille étant collée au substrat.

5. Dispositif selon l'une des revendications 1 à 3, caractérisé en ce que la couche scintillatrice est constituée d'un mélange recuit d'un liant et d'une poudre scintillatrice.

6. Dispositif selon l'une des revendications précédentes, caractérisé en ce qu'il comporte une couche réfléchissant les longueurs d'onde émises par la couche scintillatrice, cette couche réfléchissante étant interposée entre le substrat et la couche scintillatrice.

7. Dispositif selon l'une des revendications précédentes, caractérisé en ce qu'il comporte en outre une deuxième couche scintillatrice (48) collée ou pressée contre la surface supérieure des éléments photosensibles.

8. Dispositif selon la revendication 7, caractérisé en ce que les deux couches scintillatrices sont sensibles à des longueurs d'onde de rayonnement incident différentes.

9. Dispositif selon la revendication 8, caractérisé en ce que les deux scintillateurs émettent à des longueurs d'onde différentes et en ce qu'il est prévu un premier masque interposé entre la première couche scintillatrice et les éléments photosensibles, et un deuxième masque interposé entre la deuxième couche scintillatrice et les éléments photosensibles, le premier masque comportant des zones opaques et des zones transparentes pour l'une des longueurs d'onde émises, et le deuxième masque comportant des zones opaques et des zones transparentes pour l'autre longueur d'onde, les zones opaques des masques étant alternées pour affecter un élément photosensible sur deux à la détection de l'une des deux longueurs d'onde.

## Claims

1. A device for converting an image into electric signals comprising on the one hand a bar or matrix of light sensitive thin film elements deposited and photoengraved (38, 40, 42) on an insulating substrate (30), and on the other hand a scintillator substance (32), characterized in that said scintillator substance is deposited on the substrate and interposed between the substrate and the photosensitive elements.

2. A device according to claim 1, characterized in that an insulating surface egalisation layer (34) is interposed between the scintillator substance (32) and the photosensitive elements.

3. A device according to claim 2, characterized in that the insulating surface egalisation layer (34) is made of polyimide.

4. A device according to one of claims 1 to 3, characterized in that the scintillator layer (32) is a resin film filled with a scintillator powder, this film being glued onto the substrate.

5. A device according to one of claims 1 to 3, characterized in that the scintillator layer is constituted by an annealed mixture of a binder and a scintillator powder.

6. A device according to one of the preceding claims, characterized in that it comprises a layer which reflects the wavelength emitted by the scintillator layer, this reflecting layer being interposed between the substrate and the scintillator layer.

7. A device according to one of the preceding claims, characterized in that it further comprises a second scintillator layer (48) which is glued to or applied against the upper surface of the photosensitive elements.

8. A device according to claim 7, characterized in that the two scintillator layers are sensitive to different wavelengths of the incident radiation.

9. A device according to claim 8, characterized in that the two scintillators emit light at different wavelengths and that a first mask is provided which is interposed between the first scintillator layer and the photosensitive elements, and a second mask which is interposed between the second scintillator layer and the photosensitive elements, the first mask comprising opaque zones and transparent zones for one of the emitted wavelengths, whereas the second mask comprises opaque zones and transparent zones for the other wavelength, these opaque zones of the masks being alternate in order to affect every second photosensitive element to the detection of one of the two wavelengths.

## Patentansprüche

1. Vorrichtung zur Umwandlung eines Bilds in elektrische Signale, mit einer Leiste oder Matrix von lichtempfindlichen Elementen (28, 40, 42) in der Dünnschichttechnik, die auf ein isolierendes Substrat (30) aufgebracht und fotograviert sind, und mit einer Szintillatorsubstanz (32), dadurch gekennzeichnet, daß die Szintillatorsubstanz auf das Substrat aufgebracht ist und zwischen das Substrat und die lichtempfindlichen Elemente eingefügt ist.

2. Vorrichtung nach Anspruch 1, dadurch gekennzeichnet, daß eine Isolierschicht (34) zum Niveauausgleich zwischen die Szintillatorsubstanz (32) und die lichtempfindlichen Elemente eingefügt ist.

3. Vorrichtung nach Anspruch 2, dadurch gekennzeichnet, daß die isolierende Schicht (34) zum Niveauausgleich aus Polyimid ist.

4. Vorrichtung nach einem der Ansprüche 1 bis 3, dadurch gekennzeichnet, daß die Szintillatorschicht (32) eine Folie aus mit einem Szintillatorpulver vermischtem Harz ist, die auf das Substrat aufgeklebt ist.

5. Vorrichtung nach einem der Ansprüche 1 bis 3, dadurch gekennzeichnet, daß die Szintillatorschicht aus einer wärmebehandelten Mischung eines Binders und eines Szintillatorpulvers besteht.

6. Vorrichtung nach einem der vorhergehenden Ansprüche, dadurch gekennzeichnet, daß sie eine reflektierende Schicht aufweist, die die von der Szintillatorschicht emittierte Strahlung reflektiert und zwischen das Substrat und die Szintillatorschicht eingefügt ist.

7. Vorrichtung nach einem der vorhergehenden Ansprüche, dadurch gekennzeichnet, daß sie außerdem eine zweite Szintillatorschicht (48) enthält, die auf die obere Oberfläche der lichtempfindlichen Elemente aufgeklebt oder aufgepreßt ist.

8. Vorrichtung nach Anspruch 7, dadurch gekennzeichnet, daß die beiden Szintillatorschichten für unterschiedliche Wellenlängen des einfallenden Lichts empfindlich sind.

9. Vorrichtung nach Anspruch 8, dadurch gekennzeichnet, daß die beiden Szintillatoren bei unterschiedlichen Wellenlängen emittieren und daß eine erste Maske zwischen der ersten Szintillatorschicht und den lichtempfindlichen Elementen sowie eine zweite Maske zwischen die zweite Szintillatorschicht und die lichtempfindlichen Elemente eingefügt ist, wobei die erste Maske lichtundurchlässige und lichtdurchlässige Zonen für eine der emittierten Wellenlängen und die zweite Maske lichtundurchlässige und transparente Zonen für die andere Wellenlänge besitzt und wobei die lichtundurchlässigen Zonen der Masken und die durchlässigen Zonen einander abwechseln, um ein lichtempfindliches Element von zweien der Erfassung einer der beiden Wellenlängen zuzuordnen.

FIG.1a

FIG.1b

FIG.2a

FIG.2b